# EUROPEAN PATENT APPLICATION

(11) **EP 4 757 498 A1**
(43) Date of publication of application: **10.06.2026**
(21) Application number: 25209274.7
(22) Date of filing: 16.10.2025
(51) Int. Cl.: H05K 1/02, H05K 1/14, H05K 1/11

(54) **SUBSTRATE AND CONNECTOR UNIT**

(30) Priority: 06.12.2024 JP 2024213027
(71) Applicant: Japan Aviation Electronics Industry, Ltd., Tokyo 150-0043 (JP)
(72) Inventor: TANAKA, Yukitaka, Tokyo (JP); TODA, Kentaro, Tokyo (JP)
(74) Representative: INNOV-GROUP

(57) **Abstract**

A substrate having flexibility is provided. A substrate (2) according to one embodiment of the present disclosure includes: a first substrate part (2a) in which a reinforcing member (12) is disposed between folded parts of a folded flexible substrate (11), the flexible substrate (11) including a first part (11a) having a cutout (11e) and a second part (11b) extending from the first part (11a), a distal end part (11i) of the second part (11b) being disposed inside the cutout (11e) of the first part (11a); a second substrate part (2b) in which a part of the flexible substrate (11) on a side of the cutout (11e) of the first part (11a) and the distal end part of the second part (11b) the flexible substrate (11) overlap a rigid substrate (13); and a flexible part (2c) disposed between the first substrate part (2a) and the second substrate part (2b) in the flexible substrate (11).

## Description

### BACKGROUND

The present disclosure relates to a substrate and a connector unit.

For example, as shown in Fig. 16, a substrate 101 disclosed in Patent Literature 1 includes a structural component 102 and a rigid substrate 103. The structural component 102, which has a configuration in which a reinforcing plate 105 is disposed between folded parts of a flexible substrate 104, is a part to be inserted into a connection connector.

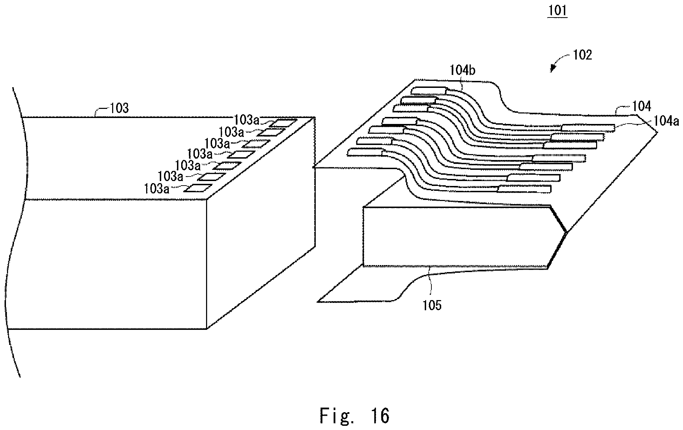

The rigid substrate 103 has a thickness which is greater than a thickness which allows insertion into the connection connector in order to form a step between the rigid substrate 103 and the structural component 102, and pads 104a of the flexible substrate 104 are connected to pads 103a of the rigid substrate 103 via wires 104b, as shown in Fig. 16. Such a substrate 101 has a robust structure as the reinforcing plate 105 of the structural component 102 and the rigid substrate 103 are bonded to each other by an adhesive.

[Patent Literature 1] Japanese Patent No. 6597810

### SUMMARY

Since the substrate 101 disclosed in Patent Literature 1 has a robust structure in which the structural component 102 and the reinforcing plate 105 are bonded to each other, there is a problem that the substrate 101 has no flexibility.

An object of the present disclosure is to provide a substrate having flexibility and a connector unit.

A substrate according to one aspect of the present disclosure includes:
a first substrate part in which a reinforcing member is disposed between folded parts of a flexible substrate that is folded, the flexible substrate including a first part having a cutout and a second part extending from the first part, a distal end part of the second part being disposed inside the cutout of the first part as seen from a thickness direction of the flexible substrate;
a second substrate part in which a part of the flexible substrate on a side of the cutout of the first part and the distal end part of the second part the flexible substrate overlap a rigid substrate in the state in which the flexible substrate is folded; and
a flexible part that is disposed between the first substrate part and the second substrate part in the flexible substrate in the state in which the flexible substrate is folded.

A connector unit according to one aspect of the present disclosure includes:
the aforementioned substrate; and
a connector connected to the substrate, in which
an engaging part provided in a reinforcing member of the substrate is capable of engaging with an engaged part disposed in the connector.

According to the present disclosure, it is possible to provide a substrate having flexibility and a connector unit.

The above and other objects, features and advantages of the present disclosure will become more fully understood from the detailed description given hereinbelow and the accompanying drawings.

### BRIEF DESCRIPTION OF DRAWINGS

Fig. 1 is a perspective view showing a connector unit according to an embodiment as seen from a positive side of a Z-axis;
Fig. 2 is a perspective view showing the connector unit according to the embodiment as seen from a negative side of the Z-axis;
Fig. 3 is an exploded perspective view showing the connector unit according to the embodiment as seen from the positive side of the Z-axis;
Fig. 4 is a perspective view showing a substrate of the connector unit according to the embodiment as seen from the positive side of the Z-axis;
Fig. 5 is a perspective view showing the substrate of the connector unit according to the embodiment as seen from the negative side of the Z-axis;
Fig. 6 is a diagram showing the substrate of the connector unit according to the embodiment as seen from a positive side of a Y-axis;
Fig. 7 is a diagram showing a flexible substate before it is folded as seen from the negative side of the Z-axis;
Fig. 8 is a perspective view showing a connector of the connector unit according to the embodiment as seen from the positive side of the Z-axis;
Fig. 9 is a perspective view showing the connector of the connector unit according to the embodiment as seen from the negative side of the Z-axis;
Fig. 10 is an exploded perspective view showing the connector of the connector unit according to the embodiment as seen from the positive side of the Z-axis;
Fig. 11 is a diagram showing a contact assembly of the connector in the connector unit according to the embodiment as seen from the positive side of the Z-axis;
Fig. 12 is a diagram showing the contact assembly of the connector in the connector unit according to the embodiment as seen from the negative side of the Z-axis;
Fig. 13 is a perspective view showing a first contact group and a second contact group in the contact assembly of the connector according to the embodiment as seen from the positive side of the Z-axis;
Fig. 14 is a diagram showing a substrate of a connector unit according to another embodiment as seen from the positive side of the Y-axis;
Fig. 15 is a diagram showing a substrate of a connector unit according to another embodiment as seen from the positive side of the Y-axis; and
Fig. 16 is a diagram showing Fig. 2 of Patent Literature 1.

### DESCRIPTION OF EMBODIMENTS

Hereinafter, with reference to the drawings, specific embodiments to which the present disclosure is applied will be described in detail. Note that the present disclosure is not limited to the following embodiments. Further, for the sake of clarity of the description, the following descriptions and the drawings are simplified as appropriate. In the following description, a three-dimensional (XYZ) coordinate system is used to clarify the explanation.

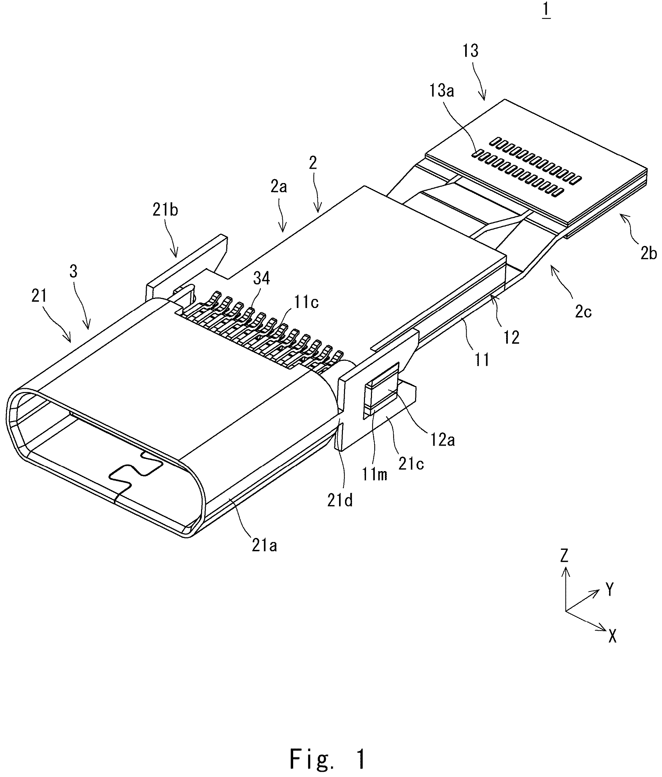

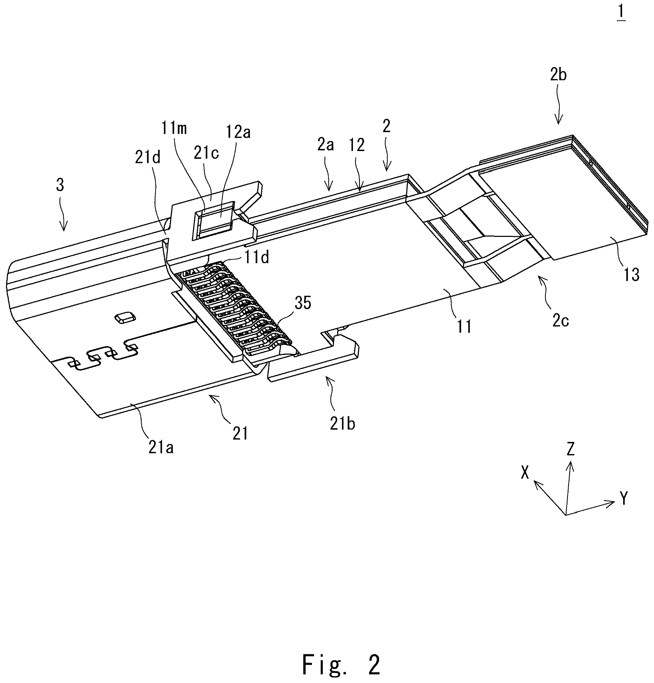

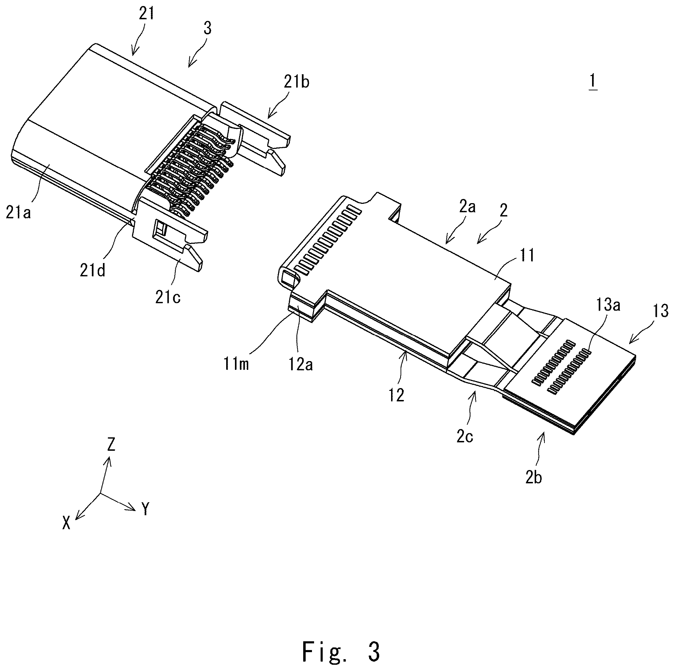

First, a configuration of a connector unit according to this embodiment will be described. Fig. 1 is a perspective view showing a connector unit according to this embodiment as seen from a positive side of a Z-axis. Fig. 2 is a perspective view showing the connector unit according to this embodiment as seen from a negative side of the Z-axis. Fig. 3 is an exploded perspective view showing the connector unit according to this embodiment as seen from the positive side of the Z-axis.

As shown in Figs. 1 to 3, for example, a connector unit 1 includes a substrate 2 and a connector 3. The substrate 2 is used, for example, to connect a mainboard on which a Central Processing Unit (CPU) and the like are mounted to the connector 3.

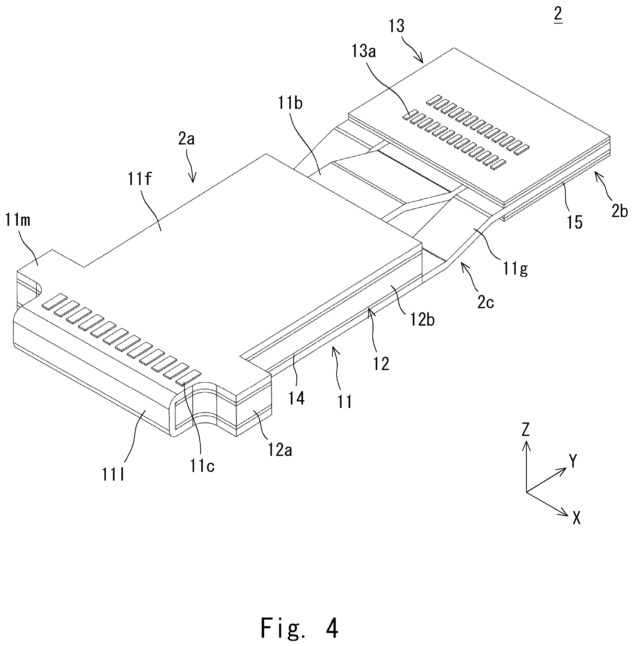

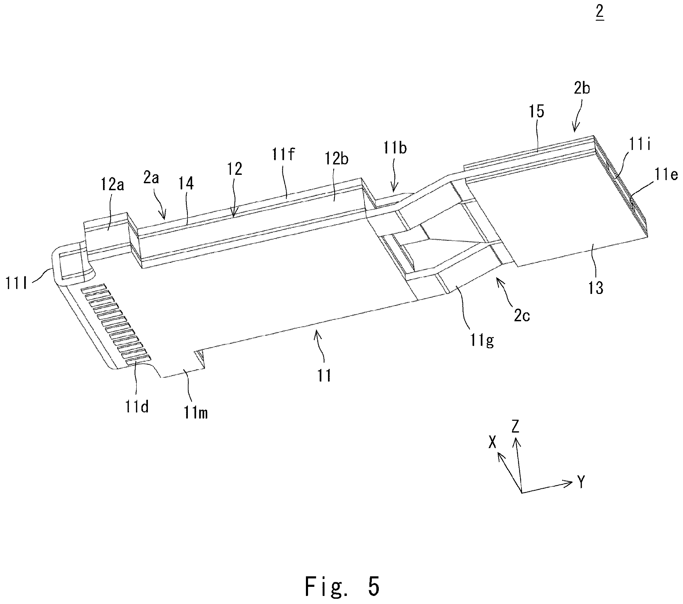

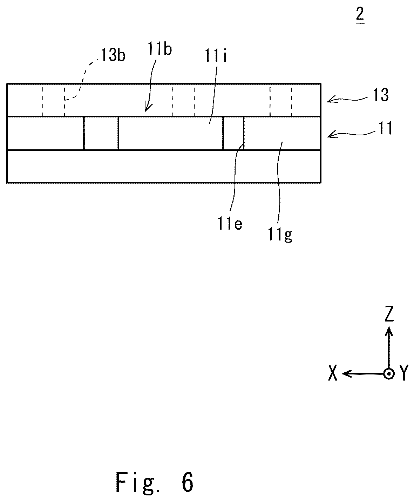

Fig. 4 is a perspective view showing the substrate of the connector unit according to this embodiment as seen from the positive side of the Z-axis. Fig. 5 is a perspective view showing the substrate of the connector unit according to this embodiment as seen from the negative side of the Z-axis. Fig. 6 is a diagram showing the substrate of the connector unit according to this embodiment as seen from a positive side of a Y-axis.

As shown in Figs. 4 and 5, the substrate 2 includes a flexible substrate 11, a reinforcing member 12, and rigid substrates 13. The flexible substrate 11 includes, for example, a base material made of a thin film such as polyimide, and is folded at an end part on the negative side of the Y-axis of the flexible substrate 11.

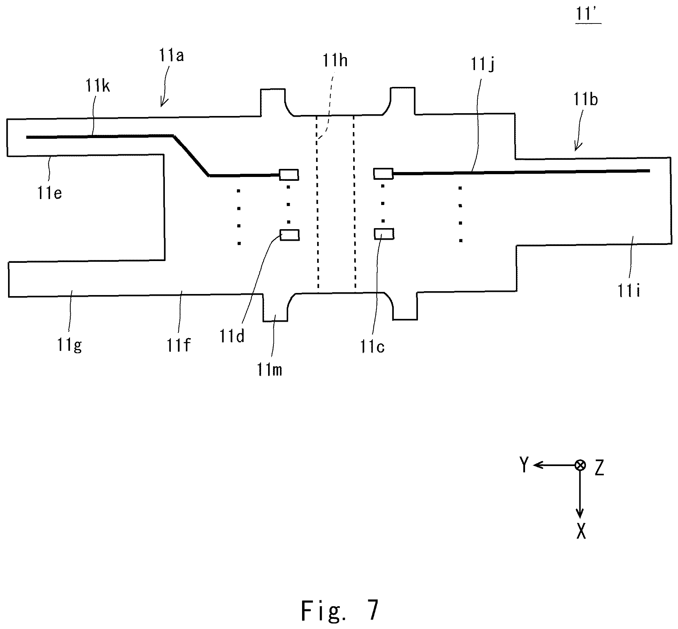

Fig. 7 is a diagram showing the flexible substate before it is folded as seen from the negative side of the Z-axis. Here, Fig. 7 shows a part of first pads, second pads, first wires, and second wire in a representative manner. Note that a symbol 11' is attached to the flexible substate before it is folded in order to differentiate it from a flexible substrate 11 after it is folded.

As shown in Fig. 7, the flexible substrate 11' includes a first part 11a, a second part 11b, first pads 11c, and second pads 11d. The first part 11a has, for example, a substantially rectangular shape that is long in the Y-axis direction as seen from the Z-axis direction, and includes a cutout 11e in a part on the positive side of the Y-axis of the first part 11a.

As shown in Fig. 7, for example, the cutout 11e has a substantially rectangular shape that is long in the Y-axis direction as seen from the Z-axis direction, and the end part on the positive side of the Y-axis of the cutout 11e is opened. The cutout 11e is disposed at substantially the center of the flexible substrate 11' in the X-axis direction.

As shown in Fig. 7, for example, a substantially rectangular third part 11f that is long in the Y-axis direction as seen from the Z-axis direction is disposed on the negative side of the Y-axis of the first part 11a with respect to the cutout 11e, and on each side of the cutout 11e in the X-axis direction, a substantially rectangular fourth part 11g that is long in the Y-axis direction as seen from the Z-axis direction extends toward the positive side of the Y-axis from the third part 11f.

As shown in Fig. 7, bending lines 11h for folding the flexible substrate 11' are set in the third part 11f. The bending lines 11h, which extend in the X-axis direction, are disposed in predetermined positions of the third part 11f in such a way that they are spaced apart from each other in the Y-axis direction, so that the folded parts of the flexible substrate 11' can sandwich the reinforcing member 12 and a distal end part (the part on the negative side of the Y-axis in Fig. 7) 11i of the second part 11b can be accommodated inside the cutout 11e.

As shown in Fig. 7, the second part 11b extends toward the negative side of the Y-axis from the first part 11a. The second part 11b is disposed at substantially the center of the first part 11a in the X-axis direction. The width dimension of the second part 11b in the X-axis direction is substantially equal to the width dimension of the cutout 11e of the first part 11a in the X-axis direction. Further, the length of the second part 11b in the Y-axis direction is substantially equal to the length of the fourth part 11g in the Y-axis direction.

As shown in Fig. 7, the first pads 11c are disposed on a surface on the negative side of the Z-axis of the third part 11f. The first pads 11c are disposed in the part of the third part 11f on the negative side of the Y-axis with respect to the bending lines 11h on the negative side of the Y-axis in such a way that they are spaced apart from each other in the X-axis direction. First wires 11j are connected to the first pads 11c. The first wires 11j extend toward the negative side of the Y-axis from the first pads 11c.

As shown in Fig. 7, the second pads 11d are disposed on the surface on the negative side of the Z-axis of the third part 11f. The second pads 11d are disposed in the part of the third part 11f on the positive side of the Y-axis with respect to the bending lines 11h on the positive side of the Y-axis in such a way that they are spaced apart from each other in the X-axis direction. Second wires 11k are connected to the second pads 11d. The second wires 11k extend toward the positive side of the Y-axis from the second pads 11d.

The aforementioned flexible substrate 11' is bent from the state shown in Fig. 7 at each bending line 11h in an approximately 90° clockwise as seen from the positive side of the X-axis, whereby a flexible substrate 11 whose end part on the negative side of the Y-axis is folded is obtained.

At this time, as shown in Figs. 5 and 6, the distal end part 11i of the second part 11b is accommodated inside the cutout 11e of the first part 11a, and the end part on the positive side of the Y-axis of the second part 11b is disposed at a position substantially equal to the end part on the positive side of the Y-axis of the fourth part 11g.

As shown in Figs. 4 and 5, the distal end part 11i of the second part 11b and the fourth part 11g are disposed so as to be substantially parallel to the XY-plane. Further, the part on the negative side of the Y-axis of the second part 11b and the part on the negative side of the Y-axis of the fourth part 11g are bent, and the distal end part 11i of the second part 11b and the part on the positive side of the Y-axis of the fourth part 11g are disposed at substantially the center of the flexible substrate 11 in the Z-axis direction.

Further, as shown in Figs. 4 and 5, the first pads 11c are disposed on the surface on the positive side of the Z-axis of the flexible substrate 11 and the second pads 11d are disposed on the surface on the negative side of the Z-axis of the flexible substrate 11.

Then, the first wires 11j and the second wires 11k extend toward the positive side of the Y-axis. Therefore, the first wires 11j and the second wires 11k are not disposed in the folded parts 111 of the flexible substrate 11.

As shown in Figs. 4 and 5, the reinforcing member 12 is disposed between folded parts of the third part 11f in the flexible substrate 11, and is fixed to the third part 11f via an adhesive member 14 having insulating properties.

As shown in Figs. 4 and 5, the reinforcing member 12 has a shape corresponding to that of the folded third part 11f in the flexible substrate 11 as seen from the Z-axis direction, and has, for example, a substantially rectangular shape that is long in the Y-axis direction. The reinforcing member 12 may have, for example, a rigidity higher than that of the flexible substrate 11 and have insulating properties.

At this time, as shown in Figs. 4 and 5, the reinforcing member 12 may include engaging parts 12a engaged with engaged parts 21c of the connector 3. The engaging parts 12a are protruded on the outward of the reinforcing member 12 in the X-axis direction from the end part on the positive side of the X-axis of the substantially rectangular part 12b and the end part on the negative side of the X-axis of the substantially rectangular part 12b in the reinforcing member 12.

As shown in Figs. 4 and 5, the engaging parts 12a have, for example, a substantially rectangular shape as seen from the Z-axis direction, and have a thickness in the Z-axis direction. Here, the engaging parts 12a may be fixed to protruding parts 11m formed in the third part 11f of the flexible substrate 11 via the adhesive member 14.

The rigid substrates 13 have a rigidity higher than that of the flexible substrate 11, and include a base material formed of Flame Retardant Type 4 (FR4) or the like. As shown in Figs. 4 and 5, the rigid substrates 13 are fixed to the second part 11b and the fourth part 11g of the flexible substrate 11 via an adhesive member 15 having insulating properties in a state in which the rigid substrates 13 sandwich the part where the distal end part 11i of the second part 11b in the flexible substrate 11 is accommodated inside the cutout 11e in the Z-axis direction.

As shown in Figs. 4 and 5, the rigid substrates 13 have, for example, a substantially rectangular shape that is long in the X-axis direction as seen from the Z-axis direction. Pads 13a are disposed on the surface on the positive side of the Z-axis of the rigid substrate 13 on the positive side of the Z-axis.

The pads 13a are connected to, for example, the first wires 11j and the second wires 11k of the flexible substrate 11 through vias 13b formed on the rigid substrate 13 as shown in Fig. 6. For example, a board-to-board connector or the like can be connected to the pads 13a. Note that Fig. 6 shows only representative vias 13b in a simplified manner.

As shown in Figs. 4 and 5, a part of the aforementioned substrate 2 where the reinforcing member 12 is disposed between folded parts of the third part 11f of the flexible substrate 11 forms a first substrate part 2a, and a part of the substrate 2 where the second part 11b and the fourth part 11g of the flexible substrate 11 are sandwiched between the rigid substrates 13 forms a second substrate part 2b.

As shown in Figs. 4 and 5, the part on the negative side of the Y-axis of the second part 11b of the flexible substrate 11 and the part on the negative side of the Y-axis of the fourth part 11g of the flexible substrate 11, which are disposed between the first substrate part 2a and the second substrate part 2b in the substrate 2, form a flexible part 2c. Accordingly, the substrate 2 can be bent at the flexible part 2c, and the substrate 2 having flexibility can be provided.

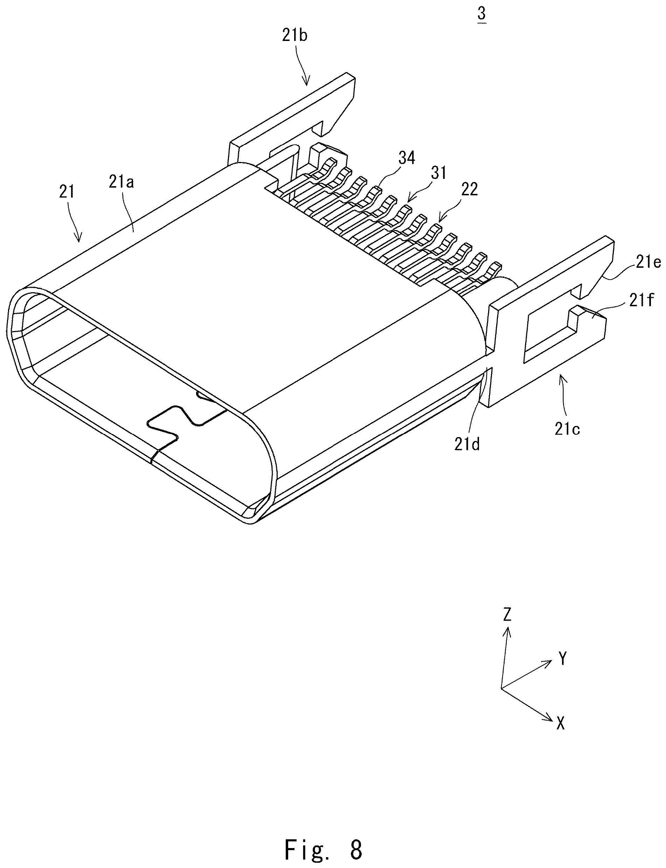

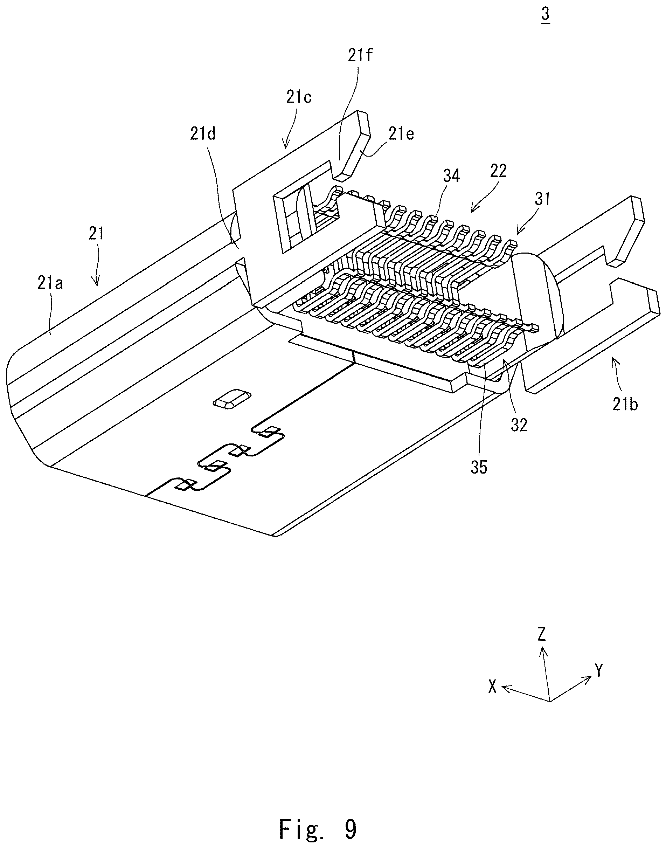

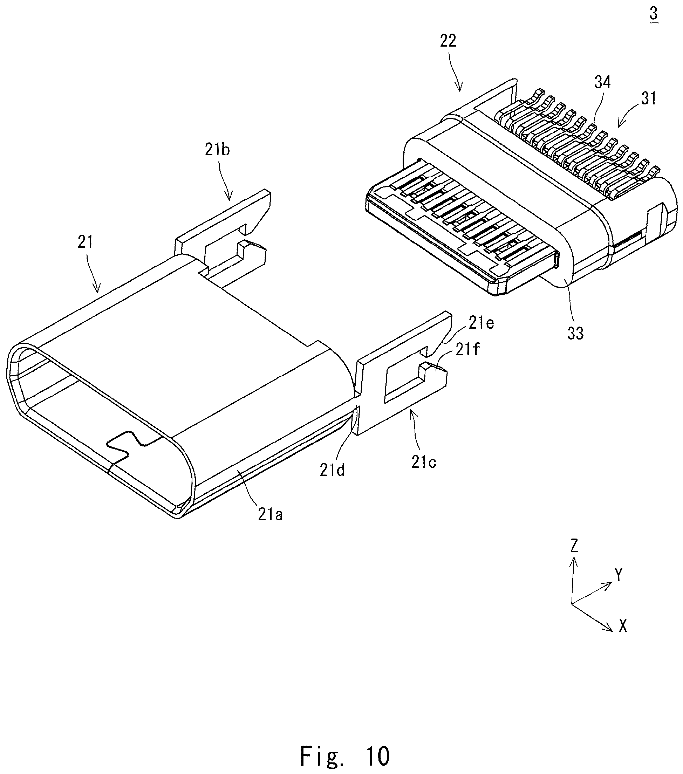

As shown in Figs. 1 and 2, the connector 3 is connected to the substrate 2. Fig. 8 is a perspective view showing the connector of the connector unit according to this embodiment as seen from the positive side of the Z-axis. Fig. 9 is a perspective view showing the connector of the connector unit according to this embodiment as seen from the negative side of the Z-axis. Fig. 10 is an exploded perspective view showing the connector of the connector unit according to this embodiment as seen from the positive side of the Z-axis.

As shown in Figs. 8 to 10, the connector 3 includes a shell 21 and a contact assembly 22. The shell 21 is formed of a conductive member. The shell 21 has, for example, a first part 21a and second parts 21b. The first part 21a has a substantially tubular shape, and extends in the Y-axis direction. The first part 21a has, for example, a substantially rectangular shape that is long in the X-axis direction as seen from the Y-axis direction.

As shown in Figs. 8 to 10, the second parts 21b are protruded on the positive side of the Y-axis from the end part on the positive side of the X-axis of the first part 21a and the end part on the negative side of the X-axis of the first part 21a. The second parts 21b each include an engaged part 21c and a coupling part 21d. The engaged part 21c has a substantially C shape whose positive side of the Y-axis is opened as seen from the X-axis direction so that the engaging part 12a of the substrate 2 can engage therewith, and is disposed so as to be substantially parallel to the YZ-plane.

As shown in Figs. 8 to 10, end parts on the positive side of the Y-axis of each of the engaged parts 21c are bent toward the inner side of the opened part of the engaged part 21c so as to reduce the height of the opened part of the engaged part 21c in the Z-axis direction. Then, the inside of the engaged parts 21c has a substantially rectangular shape as seen from the X-axis direction, and the height of the inside of the engaged parts 21c in the Z-axis direction is substantially equal to the height of the engaging parts 12a of the substrate 2 in the Z-axis direction.

At this time, as shown in Figs. 8 to 10, the engaged parts 21c may each include, at the end part on the positive side of the Y-axis of a bent part 21f in the engaged part 21c, an inclined part 21e that is inclined on the inward of the opened part of the engaged part 21c in the Z-axis direction toward the negative side of the Y-axis.

As shown in Figs. 8 to 10, the coupling parts 21d each couple the first part 21a to the engaged part 21c. The coupling parts 21d have, for example, a substantially rectangular shape as seen from the Y-axis direction, and extend in the Y-axis direction.

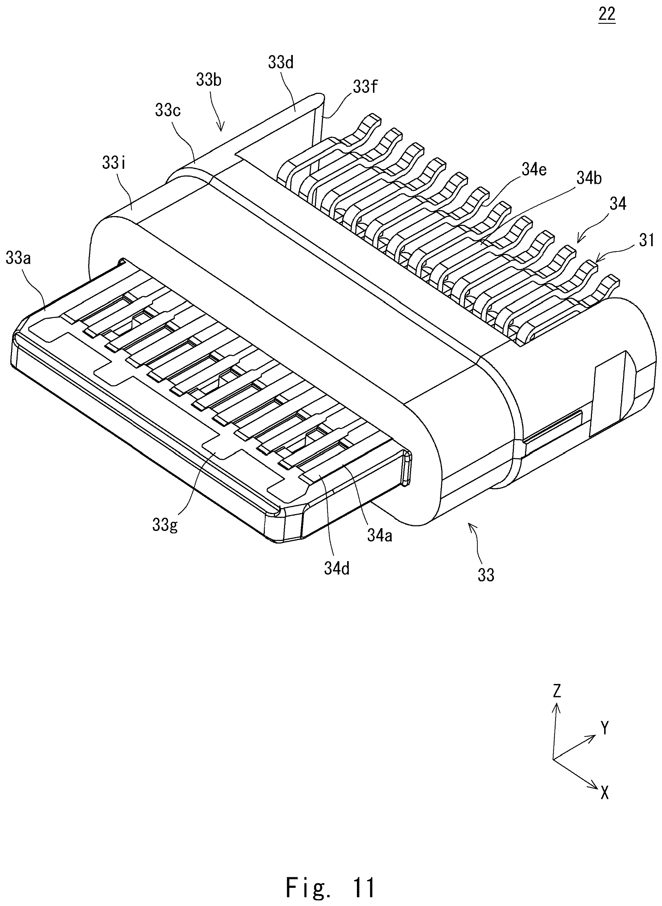

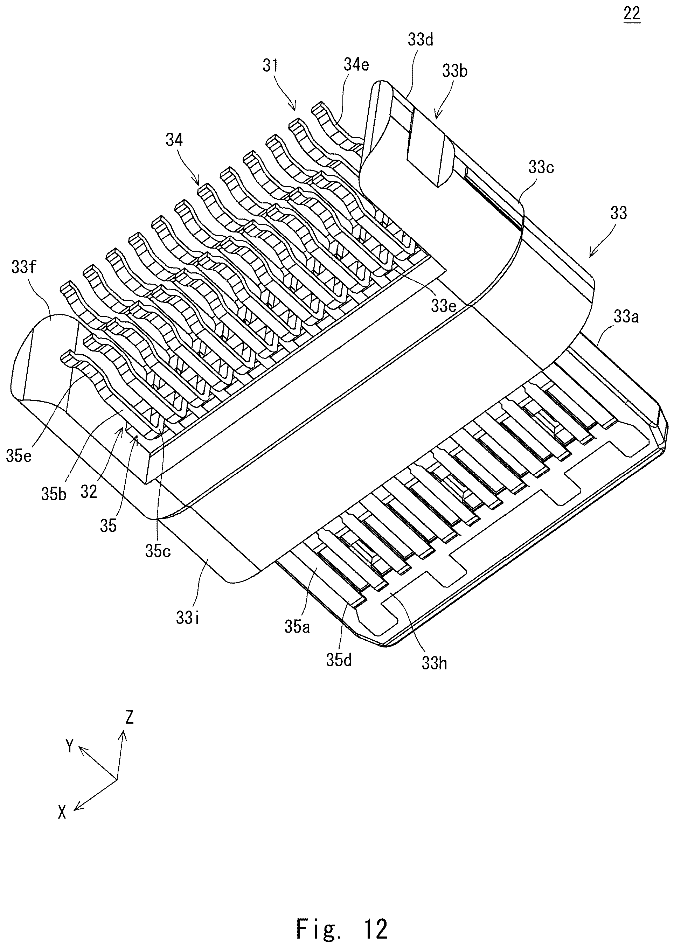

As shown in Figs. 8 and 9, the contact assembly 22 is inserted into the first part 21a of the shell 21 and held therein. Fig. 11 is a diagram showing the contact assembly of the connector in the connector unit according to this embodiment as seen from the positive side of the Z-axis. Fig. 12 is a diagram showing the contact assembly of the connector in the connector unit according to this embodiment as seen from the negative side of the Z-axis.

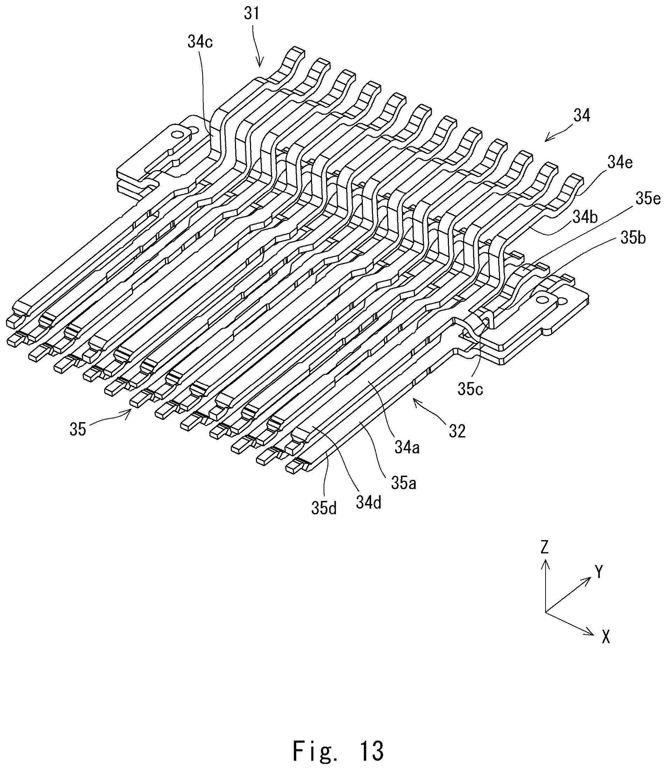

Fig. 13 is a perspective view showing a first contact group and a second contact group in the contact assembly of the connector according to this embodiment as seen from the positive side of the Z-axis. As shown in Figs. 11 to 13, the contact assembly 22 includes a first contact group 31, a second contact group 32, and an insulating member 33.

As shown in Figs. 11 to 13, the first contact group 31 includes a plurality of contacts 34. The contacts 34 are disposed in such a way that they are spaced apart from each other in the X-axis direction. The contacts 34 are, for example, substantially Z-shaped compression contacts as seen from the X-axis direction, and each of the contacts 34 includes a first part 34a, a second part 34b, and a third part 34c.

As shown in Fig. 13, for example, the first part 34a extends in the Y-axis direction. A part on the negative side of the Y-axis of the first part 34a forms a first electric contact 34d connected to a contact of the connection connector.

As shown in Fig. 13, for example, the second part 34b extends in the Y-axis direction. A part on the positive side of the Y-axis of the second part 34b forms a second electric contact 34e connected to the first pad 11c of the first substrate part 2a of the substrate 2.

As shown in Fig. 13, for example, the second electric contact 34e is curved in a substantially C shape whose positive side of the Z-axis is opened as seen from the X-axis direction. The third part 34c extends, for example, in the Z-axis direction, and couples the end part on the positive side of the Y-axis of the first part 34a to the end part on the negative side of the Y-axis of the second part 34b.

As shown in Fig. 13, the second contact group 32 includes a plurality of contacts 35. The contacts 35 have, for example, a plane-symmetrical shape with an XY-plane as a plane of symmetry with respect to the contacts 34 of the first contact group 31, and are disposed in such a way that they are spaced apart from each other in the X-axis direction.

Specifically, as shown in Fig. 13, the contacts 35 each include a first part 35a including a first electric contact 35d connected to a contact of the connection connector, a second part 35b including a second electric contact 35e connected to the second pad 11d of the first substrate part 2a of the substrate 2, and a third part 35c that couples the first part 35a to the second part 35b.

As shown in Figs. 11 and 12, the insulating member 33 is an insulator (housing) that holds the first contact group 31 and the second contact group 32. The insulating member 33 includes a first part 33a and a second part 33b.

As shown in Figs. 11 and 12, for example, the first part 33a has, for example, a flat plate shape that is substantially parallel to the XY-plane, and has a substantially rectangular shape that is long in the X-axis direction as seen from the Y-axis direction. The first part 33a has a shape corresponding to the shape of the insulating member of the connection connector in such a way that the insulating member that holds contacts in the connection connector can mate with the first part 33a.

As shown in Fig. 11, the first parts 34a of the contacts 34 of the first contact group 31 are exposed from a surface on the positive side of the Z-axis of the first part 33a. Further, as shown in Fig. 12, the first parts 35a of the contacts 35 of the second contact group 32 are exposed from a surface on the negative side of the Z-axis of the first part 33a.

As shown in Figs. 11 and 12, the second part 33b, which is disposed on the positive side of the Y-axis with respect to the first part 33a, is continuous with the first part 33a. The second part 33b, which is a substantially C shape whose positive side of the Y-axis is opened as seen from the Z-axis direction, includes a wall part 33c and protruding parts 33d.

As shown in Figs. 11 and 12, for example, the wall part 33c is a substantially rectangular shape that is long in the X-axis direction as seen from the Y-axis direction, and has an outer shape that is substantially equal to the inner shape of the first part 21a of the shell 21. The wall part 33c has a thickness in the Y-axis direction, and is protruded on the outward of the insulating member 33 with respect to the first part 33a as seen from the Y-axis direction.

As shown in Fig. 12, the wall part 33c includes a plurality of penetrating parts 33e. The penetrating parts 33e extend in the Y-axis direction, and the first parts 34a of the contacts 34 of the first contact group 31 and the first parts 35a of the contacts 35 of the second contact group 32 are made to pass therethrough. That is, the contacts 34 of the first contact group 31 and the contacts 35 of the second contact group 32 are aligned in the wall part 33c.

As shown in Figs. 11 and 12, the part on the positive side of the Y-axis including the third parts 34c of the contacts 34 in the first contact group 31 and the part on the positive side of the Y-axis including the third parts 35c of the contacts 35 in the second contact group 32 are protruded from the wall part 33c on the positive side of the Y-axis.

As shown in Figs. 11 and 12, for example, the protruding parts 33d are protruded on the positive side of the Y-axis from the end part on the positive side of the X-axis of the wall part 33c and the end part on the negative side of the X-axis of the wall part 33c. The protruding parts 33d have a substantially rectangular shape that is long in the Y-axis direction as seen from the X-axis direction.

At this time, the gap between the protruding part 33d on the positive side of the X-axis and the protruding part 33d on the negative side of the X-axis in the X-axis direction may be substantially equal to the width dimension of the end part on the negative side of the Y-axis of the first substrate part 2a in the substrate 2 in the X-axis direction. Further, as shown in Figs. 11 and 12, the protruding parts 33d may each include, in the end part on the positive side of the Y-axis of the protruding part 33d, a curved part 33f that curves on the inward of the insulating member 33 toward the negative side of the Y-axis.

As shown in Figs. 11 and 12, the part on the positive side of the Y-axis including the third parts 34c of the contacts 34 in the first contact group 31 and the part on the positive side of the Y-axis including the third parts 35c of the contacts 35 in the second contact group 32 are disposed in the space formed of the wall part 33c and the protruding parts 33d as seen from the Z-axis direction.

As shown in Figs. 11 and 12, the insulating member 33 may be divided into a first insulating member 33g that holds the first contact group 31, a second insulating member 33h that holds the second contact group 32, and a third insulating member 33i that holds the first insulating member 33g and the second insulating member 33h.

The aforementioned contact assembly 22 is inserted into the first part 21a of the shell 21 from the positive side of the Y-axis toward the negative side of the Y-axis, whereby the contact assembly 22 is held in the first part 21a of the shell 21, as shown in Figs. 11 and 12.

At this time, as shown in Figs. 8 and 9, the part on the positive side of the Y-axis including the third parts 34c of the contacts 34 in the first contact group 31, the part on the positive side of the Y-axis including the third parts 35c of the contacts 35 in the second contact group 32, and the protruding parts 33d of the second part 33b of the insulating member 33 are protruded from the first part 21a on the positive side of the Y-axis between the second parts 21b of the shell 21.

Next, a flow of manufacturing the substrate 2 in the connector unit 1 according to this embodiment will be described. First, for example, the reinforcing member 12 is fixed, via the adhesive member 14, to the part on the positive side of the Y-axis with respect to the bending lines 11h on the positive side of the Y-axis in the third part 11f of the flexible substrate 11' that is not folded.

Next, the third part 11f of the flexible substrate 11' is bent along the bending lines 11h and the third part 11f is folded so as to hold the reinforcing member 12 therebetween, and the reinforcing member 12 is fixed, via the adhesive member 14, to the part of the third part 11f disposed on the positive side of the Z-axis.

Next, the part on the negative side of the Y-axis of the second part 11b of the flexible substrate 11 and the part on the negative side of the Y-axis of the fourth part 11g of the flexible substrate 11 are bent, and the distal end part 11i of the second part 11b and the part on the positive side of the Y-axis of the fourth part 11g are disposed at substantially the center of the flexible substrate 11 in the Z-axis direction while accommodating the distal end part 11i of the second part 11b inside the cutout 11e of the first part 11a.

Next, while sandwiching, by the rigid substrates 13, the part of the flexible substrate 11 where the distal end part 11i of the second part 11b is accommodated inside the cutout 11e, the rigid substrates 13 are fixed to the second part 11b and the fourth part 11g of the flexible substrate 11 via the adhesive member 15.

Then, the pads 13a of the rigid substrate 13 on the positive side of the Z-axis are connected to the first wires 11j and the second wires 11k of the flexible substrate 11 through the vias 13b, whereby the substrate 2 including the first substrate part 2a, the second substrate part 2b, and the flexible part 2c can be manufactured.

Next, a flow of manufacturing the connector 3 of the connector unit 1 according to this embodiment will be described. First, the contacts 34 of the first contact group 31 and the contacts 35 of the second contact group 32 are insert-molded into the insulating member 33, thereby forming the contact assembly 22.

At this time, first, the contacts 34 of the first contact group 31 are insert-molded into the first insulating member 33g and held in the first insulating member 33g, and the contacts 35 of the second contact group 32 are insert-molded into the second insulating member 33h and held in the second insulating member 33h.

Then, the first insulating member 33g and the second insulating member 33h may be insert-molded into the third insulating member 33i. Accordingly, they may be insert-molded into the third insulating member 33i in a state in which the contacts 34 of the first contact group 31 and the contacts 35 of the second contact group 32 are accurately aligned.

Next, the contact assembly 22 is inserted into the first part 21a of the shell 21 toward the negative side of the Y-axis from the positive side of the Y-axis and the first part 21a of the shell 21 is caused to hold the contact assembly 22, whereby the connector 3 can be manufactured.

Next, a flow of connecting the substrate 2 to the connector 3 in the connector unit 1 according to this embodiment will be described. First, the substrate 2 is made to come close to the connector 3 from the positive side of the Y-axis toward the negative side of the Y-axis, and the engaging parts 12a of the reinforcing member 12 in the substrate 2 are inserted into the engaged parts 21c of the shell 21 in the connector 3 and engaged therewith while causing the end part on the negative side of the Y-axis of the first substrate part 2a of the substrate 2 to be inserted between the protruding parts 33d of the insulating member 33 of the connector 3.

In addition, the end part on the negative side of the Y-axis of the first substrate part 2a of the substrate 2 is inserted between the second parts 34b of the contacts 34 of the first contact group 31 of the connector 3 and the second parts 35b of the contacts 35 of the second contact group 32 of the connector 3, and the second electric contacts 34e of the first contact group 31 of the connector 3 and the second electric contacts 35e of the second contact group 32 of the connector 3 are connected to the first pads 11c and the second pads 11d of the first substrate part 2a of the substrate 2. That is, the connector 3 according to this embodiment is connected to the substrate 2 by solderless means.

Accordingly, the substrate 2 can be connected to the connector 3. At this time, when the height of the inside of the engaged parts 21c of the shell 21 in the Z-axis direction is substantially equal to the height of the engaging parts 12a of the substrate 2 in the Z-axis direction, the position of the substrate 2 with respect to the connector 3 in the Z-axis direction can be fixed.

Further, when the gap between the protruding part 33d on the positive side of the X-axis of the insulating member 33 in the connector 3 and the protruding part 33d on the negative side of the X-axis of the insulating member 33 in the connector 3 in the X-axis direction is substantially equal to the width dimension in the X-axis direction of the end part on the negative side of the Y-axis of the first substrate part 2a in the substrate 2, the position of the substrate 2 with respect to the connector 3 in the X-axis direction can be fixed.

Further, when the engaged parts 21c of the shell 21 include the inclined parts 21e, the engaging parts 12a of the reinforcing member 12 in the substrate 2 can be smoothly inserted into the engaged parts 21c of the shell 21 in the connector 3 and engaged therewith.

Further, when the protruding parts 33d of the insulating member 33 in the connector 3 include the curved parts 33f, the end part on the negative side of the Y-axis of the first substrate part 2a of the substrate 2 can be smoothly inserted between the protruding parts 33d.

Next, a flow of replacing the substrate 2 or the connector 3 by another one in the connector unit 1 according to this embodiment will be described. In the connector unit 1 according to this embodiment, the engaging parts 12a of the substrate 2 and the engaged parts 21c of the connector 3 are engaged with each other, whereby the substrate 2 and the connector 3 are connected to each other.

Therefore, when the engaging state of the engaging parts 12a of the substrate 2 with the engaged parts 21c of the connector 3 is released, the substrate 2 or the connector 3 can be replaced by another one. In particular, when the substrate 2 and the connector 3 are connected by solderless means, the substrate 2 or the connector 3 can be easily replaced by another one.

The connection connector can be connected to the aforementioned connector unit 1 in a state in which, for example, the connector unit 1 is connected to a motherboard or the like of electrical equipment. For example, the connection connector is inserted into the first part 21a of the shell 21 in the connector 3 from the negative side of the Y-axis toward the positive side of the Y-axis.

Then, contacts of the connection connector are connected to the first electric contacts 34d of the contacts 34 of the first contact group 31 of the connector 3 and the first electric contacts 35d of the contacts 35 of the second contact group 32 of the connector 3. Accordingly, the connection connector can be connected to the connector 3 of the connector unit 1.

As described above, the substrate 2 and the connector unit 1 according to this embodiment include the flexible part 2c between the first substrate part 2a and the second substrate part 2b. Therefore, the substrate 2 can be bent in the flexible part 2c and the substrate 2 having flexibility can be provided.

In addition, since the flexible substrate 11 is formed to be folded in the substrate 2 and the connector unit 1 according to this embodiment, it is unnecessary, for example, to separately form a flexible substrate on the positive side of the Z-axis and a flexible substrate on the negative side of the Z-axis, and thus the substrate 2 can be manufactured at a low cost.

Further, in the substrate 2 and the connector unit 1 according to this embodiment, the first wires 11j and the second wires 11k of the first substrate part 2a of the substrate 2 are not disposed in the folded part 11l of the flexible substrate 11. Therefore, with the substrate 2 and the connector unit 1 according to this embodiment, degradation of signal transmission characteristics can be prevented or reduced.

When the distal end part 11i of the second part 11b of the flexible substrate 11 is accommodated inside the cutout 11e of the first part 11a in the substrate 2 and the connector unit 1 according to this embodiment, the thickness of the second substrate part 2b of the substrate 2 in the Z-axis direction can be reduced.

When, for example, the rigid substrate 13 on the negative side of the Z-axis includes pads, pads of the rigid substrate 13 on the negative side of the Z-axis are also connected to the first wires 11j and the second wires 11k of the flexible substrate 11 through vias.

In this case, the height of the vias 13b of the rigid substrate 13 on the positive side of the Z-axis and the height of the vias of the rigid substrate 13 on the negative side of the Z-axis can be made substantially equal to each other in the Z-axis direction. Accordingly, the signal transmission path can be made substantially the same and degradation of signal transmission characteristics can be prevented or reduced.

When the engaging parts 12a of the substrate 2 and the engaged parts 21c of the connector 3 can be engaged with each other in the substrate 2 and the connector unit 1 according to this embodiment, the substrate 2 or the connector 3 can be easily replaced by another one with respect to electrical equipment.

When the substrate 2 and the connector 3 are connected to each other by solderless means in the substrate 2 and the connector unit 1 according to this embodiment, it is possible to prevent or reduce a decrease in impedance, which can contribute to improving signal transmission characteristics compared to the case in which the substrate 2 and the connector 3 are connected to each other by soldering.

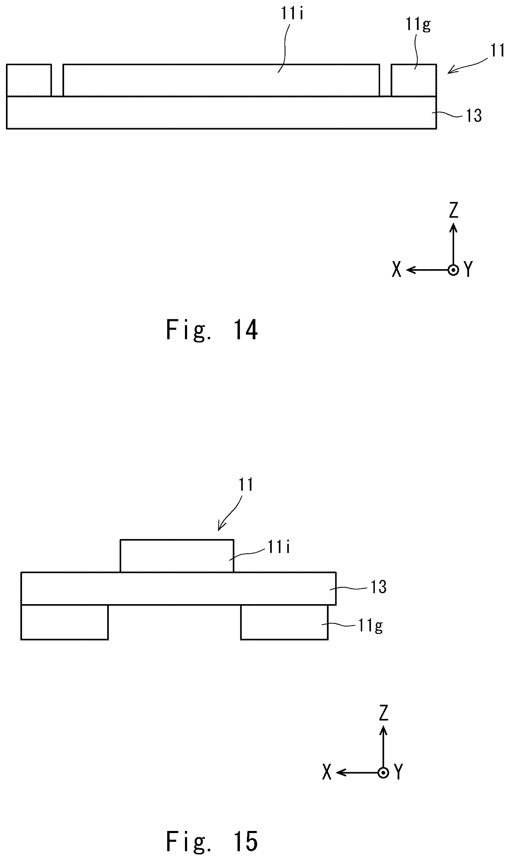

While the second substrate part 2b of the substrate 2 according to this embodiment is configured in such a way that the flexible substrate 11 is sandwiched by the rigid substrates 13, the rigid substrates 13 may be disposed on only the positive side of the Z-axis or only the negative side of the Z-axis with respect to the flexible substrate 11, as shown in Fig. 14. Further, as shown in Fig. 15, the rigid substrate 13 may be sandwiched by the distal end part 11i of the second part 11b and the fourth part 11g of the flexible substrate 11.

The substrate 2 according to this embodiment is merely an example. It is sufficient that the substrate 2 include the flexible part 2c between the first substrate part 2a and the second substrate part 2b. Further, it is sufficient that the flexible substrate 11' have such a shape that the distal end part 11i of the second part 11b can be disposed inside the cutout 11e of the first part 11a as seen from the Z-axis direction in a state in which the flexible substrate 11' is folded.

The configuration of the connector 3 according to this embodiment is merely an example, and it it sufficient that the connector 3 be configured in such a way that at least the engaging part 12a of the substrate 2 can engage therewith. Further, the shape of the engaging part 12a of the substrate 2 is also an example, and it is sufficient that the substrate 2 and the connector 3 be capable of engaging with each other.

From the disclosure thus described, it will be obvious that the embodiments of the disclosure may be varied in many ways. Such variations are not to be regarded as a departure from the spirit and scope of the disclosure, and all such modifications as would be obvious to one skilled in the art are intended for inclusion within the scope of the following claims.

## Claims

1. A substrate (2) comprising:
a first substrate part (2a) in which a reinforcing member (12) is disposed between folded parts of a flexible substrate (11) that is folded, the flexible substrate (11) including a first part (11a) having a cutout (11e) and a second part (11b) extending from the first part (11a), a distal end part (11i) of the second part (11b) being disposed inside the cutout (11e) of the first part (11a) as seen from a thickness direction of the flexible substrate (11);
a second substrate part (2b) in which a part of the flexible substrate (11) on a side of the cutout (11e) of the first part (11a) and the distal end part (11i) of the second part (11b) the flexible substrate (11) overlap a rigid substrate (13) in the state in which the flexible substrate (11) is folded; and
a flexible part (2c) that is disposed between the first substrate part (2a) and the second substrate part (2b) in the flexible substrate (11) in the state in which the flexible substrate (11) is folded.

2. The substrate (2) according to claim 1, comprising:
a first pad (11c) that is formed in one of the folded parts of the flexible substrate (11) having the reinforcing member (12) interposed therebetween; and
a second pad (11d) that is formed in another one of the folded parts of the flexible substrate (11) having the reinforcing member (12) interposed therebetween,
wherein a first wire (11j) connected to the first pad (11c) and a second wire (11k) connected to the second pad (11d) extend toward the second substrate part (2b).

3. The substrate (2) according to claim 1 or 2, wherein the distal end part (11i) of the second part (11b) is accommodated inside the cutout (11e) of the first part (11a).

4. The substrate (2) according to claim 3, wherein, in the second substrate part (2b), a part of the flexible substrate (11) on a side of the cutout (11e) of the first part (11a) and the distal end part (11i) of the second part (11b) the flexible substrate (11) are sandwiched by the rigid substrate (13).

5. The substrate (2) according to claim 1 or 2, wherein, in the second substrate part (2b), a part of the flexible substrate (11) on a side of the cutout (11e) of the first part (11a) and the distal end part (11i) of the second part (11b) the flexible substrate (11) sandwich the rigid substrate (13).

6. The substrate (2) according to claim 1 or 2, wherein the reinforcing member (12) includes an engaging part (12a) that is capable of engaging with an engaged part (21c) of the connector (3) to which the substrate (2) is connected.

7. A connector unit (1) comprising:
the substrate (2) according to claim 1 or 2; and
a connector (3) connected to the substrate (2),
wherein an engaging part (12a) disposed in a reinforcing member (12) of the substrate (2) is capable of engaging with an engaged part (21c) disposed in the connector (3).
